**Europäisches Patentamt**

**European Patent Office**

**Office européen des brevets**

(19)

(11) Veröffentlichungsnummer : **0 323 434 B1**

(12) **EUROPÄISCHE PATENTSCHRIFT**

(45) Veröffentlichungstag der Patentschrift :
**04.03.92 Patentblatt 92/10**

(21) Anmeldenummer : **88890312.7**

(22) Anmeldetag : **07.12.88**

(51) Int. Cl.$^5$ : **B32B 15/18,** B32B 15/20,
B23B 27/14, C23C 16/30,
C23C 14/18

(54) **Verschleissteil und Verfahren zu seiner Herstellung.**

(30) Priorität : **24.12.87 AT 3429/87**

(43) Veröffentlichungstag der Anmeldung :
**05.07.89 Patentblatt 89/27**

(45) Bekanntmachung des Hinweises auf die
Patenterteilung :
**04.03.92 Patentblatt 92/10**

(84) Benannte Vertragsstaaten :
**BE CH DE FR GB IT LI LU NL SE**

(56) Entgegenhaltungen :
AT-B- 377 786
DE-A- 3 030 149
DE-A- 3 532 733
GB-A- 2 170 226

(56) Entgegenhaltungen :
US-A- 3 874 900
US-A- 3 882 579
US-A- 4 169 913
US-A- 4 643 620
**PATENT ABSTRACTS OF JAPAN, unexamined
applications, C. Field, Band 10, Nr. 292, 3.
Oktober 1986 THE PATENT OFFICE JAPA-
NESE GOVERNMENT, Seite 145 C 376**

(73) Patentinhaber : **BÖHLER Gesellschaft m.b.H.
Elisabethstrasse 12
A-1010 Wien (AT)**

(72) Erfinder : **Pacher, Oskar, Dr.
Kleinweg Nr. 6
A-8041 Graz (AT)**
Erfinder : **Leban, Karl, Dipl.-Ing.
Raugasse 4
A-2700 Wiener Neustadt (AT)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft einen Verschleißteil, insbesondere ein Werkzeug mit einem Grundkörper aus einer aluminiumhältigen Eisenbasislegierung, vorzugsweise Werkzeugstahl, insbesondere Schnellarbeitsstahl.

Aufgabe der Erfindung ist es, Verschleißteile herzustellen, die mit einer Hartstoffschicht beschichtet sind, die eine verbesserte Bindung zum Legierungskörper aufweist, um die Lebensdauer und die Einsatzmöglichkeiten der Verschleißteile, z.B. durch Steigerung des Vorschubs beim Zerspanen, zu erhöhen.

Das Legieren von Eisenbasiswerkstoffen mit Aluminium ist zur Verbesserung ihrer Gußeigenschaften und ihrer Verarbeitbarkeit bekannt. Bei Stählen für Verschleißteile bzw. Werkzeuge hat sich hingegen das Zulegieren von Aluminium in der Regel nicht sonderlich bewährt, da Aluminium eine hohe chemische Affinität besitzt und bei der Warmumformung und der Zerspanung zu unerwünschten Verklebungsreaktionen führt. Eine überzeugende und universelle Leistungssteigerung mit aluminiumlegierten Werkzeugen wurde nicht erreicht.

Um die auch bei anderen Werkzeugwerkstoffen, gegebenenfalls in geringerem Maße auftretenden Verklebungsreaktionen geringer zu halten und zur Verminderung des Verschleißes von Schneidwerkzeugen wurde gemäß US-PS 3 882 579 (Peacock) eine Beschichtung mit Metall, insbesondere mit Ti, Cr, Hf, Zr oder mit einer, mindestens eines dieser Elemente enthaltenden Legierung vorgeschlagen, wobei eine Diffusionszone zwischen dem Substrat und der Metallbeschichtung gebildet wird. Aufgrund der relativ weichen Metallschicht weisen, auch bei oberflächlicher Oxidation derselben, derartig beschichtete Werkzeuge nur eine geringe Verbesserung des Verschleißverhaltens für einige Anwendungsgebiete auf.

Es ist ferner bekannt, Leistungssteigerungen zu erreichen, indem auf Formkörpern etwa 1 bis 5 $\mu$m dicke Hartstoffbeschichtungen aus Nitriden, z.B. aus TiN oder HfN abgelagert werden. Diese Leistungssteigerungen sind in erster Linie auf die hohe Verschleißfestigkeit der aufgetragenen Hartstoffe zurückzuführen. Beispielsweise beschreibt die JP-A 61-110 770 (Sumitomo) ein Hartmetallwerkzeug für die Warmformgebung, welches thermischen und/oder thermoschockartigen Belastungen ausgesetzt ist und zur Verschleißminderung bzw. Standzeiterhöhung eine Beschichtung der Werkzeugoberfläche mit wenigstens einer Verbindung von TiC, TiN, Ti(CN), Ti(CO), Ti(CNO) und $Al_2O_3$ mit einer Dicke von 5 $\mu$m bis 1 mm aufweist. Eine gewünschte Leistungssteigerung eines derartigen Werkzeuges ist jedoch zumeist nicht erreichbar, weil die Hartstoffschicht aufgrund der nicht ausreichenden Haftfestigkeit am Grundmaterial abplatzen kann.

Die hohe Verschleißfestigkeit von Hartstoffschichten kann nur dann voll ausgenutzt werden, wenn die Haftfestigkeit der Schicht am Substrat entsprechend und die mechanischen Eigenschaften der Beschichtung gut sind. Um die Verformbarkeit und die Verschleißeigenschaften einer Beschichtung vorteilhaft zu ändern, wurde auch gemäß US-PS 4 169 913 (Kobayashi) vorgeschlagen, in die Hartstoffschicht vermehrt Kristallgitterströmungen einzubringen um dadurch eine Verbesserung der mechanischen Eigenschaften sowie des Rißverhaltens zu erreichen.

Eine höhere Gitterströmungsdichte, welche mittels der Halbwertsbreite im Röntgenstrahlbeugungsspektrum bestimmbar ist, kann jedoch die Haftfestigkeit der Schicht auf dem Substrat nur geringfügig beeinflussen.

Weiters wurde auch zur Erhöhung der Biegefestigkeit des Verbundkörpers, insbesondere für Wendeschneidplatten bei unterbrochenem Schnitt, vorgeschlagen (DE-OS 35 32 733, VEB Werkzeugkombinat Schmalkalden), die Schichtstruktur zu ändern bzw. das Stengelwachstum des Überzuges bei der Beschichtung durch Aufbringung mehrerer granular gewachsener Schichten gleicher chemischer Bestandteile mit unterschiedlichem Gefüge zu verbinden. Diese geänderte Struktur der Beschichtung beeinflußt jedoch nicht wesentlich deren Haftfestigkeit am Substrat.

Die Anstrengungen, die Haftfestigkeit von Hartstoffschichten zu verbessern, waren vielfältig; es wurden auch chemische und physikalische, z.B. Oberflächenreinigungsverfahren, wie Ionenätzen mit reaktiven und nichtreaktiven Komponenten usw. verwendet, die sich jedoch alle nur für bestimmte Legierungszusammensetzungen bzw. bestimmte Schichten bewährt haben.

Auch wurde versucht, geometrische Einflüsse zu nutzen; so wird beispielsweise in der US-PS 4 643 620 (Fujii) ein beschichteter Hartmetall-Schneideinsatz bekanntgemacht, der besondere Zähigkeit und Verschleißfestigkeit aufweisen soll, wobei die Eigenschaftsverbesserungen durch eine kontinuierliche Vergrößerung der Beschichtungsdicke in Richtung distal von der Schneidkante begründet werden. Änderungen der Beschichtungsdicke können gegebenenfalls die mechanischen Spannungen in der Schicht beeinflussen, deren Haftfestigkeit auf einem Substrat wird dadurch jedoch nicht wesentlich verbessert.

Ziel der Erfindung ist es, bei einem Verschleißteil der eingangs genannten Art eine optimale Haftfestigkeit von Hartstoffschichten zu erreichen. Dies wird erfindungsgemäß dadurch erreicht, daß der das Aluminium in einem Ausmaß von 0,1 bis 6 Gew.-%, vorzugsweise 0,2 bis 2,5 Gew.-%, insbesondere 1 bis 1,6 Gew.-%, enthaltende Grundkörper des Verschleißteiles zumindest an seiner Verschleißfläche mit zumindest einer durch PVD- oder Plasma-CVD-Beschichtungsverfahren abgelagerten Hartstoffschicht versehen ist, wobei die Hartstoffschicht im wesentlichen aus Nitriden und/oder Oxinitriden und/oder Carbiden und/oder Carbonitriden und-

/oder Oxicarbonitriden der Metalle Ti und/oder Hf und/oder Zr und gegebenenfalls Al aufgebaut ist.

Die Haftfestigkeit der Hartstoffschichten wird noch verbessert, wenn zwischen der Hartstoffschicht und dem Legierungsmaterial bzw. dem Substrat eine neben den Nitriden und/oder Oxinitriden und/oder Carbiden und/oder Carbonitriden und/oder Oxicarbonitriden der Metalle Ti und/oder Hf und/oder Zr und gegebenenfalls Al auch die Metalle selbst enthaltende Zwischenschicht aufgebaut ist.

Es zeigte sich, daß für die Erreichung einer optimalen Haftfestigkeit sowohl der Gehalt des zu beschichtenden Grundkörpers an Legierungsmaterial als auch der Aufbau und die Aufbringungsweise der Hartstoffschicht von Bedeutung ist. Insbesondere wird durch den Zusatz von Aluminium als Legierungsmaterial eine verbesserte Haftfestigkeit der Hartstoffschicht erreicht, da aufgrund der Wechselwirkung des Aluminiums mit dem Hartstoff die Haftung erhöht wird.

Im Gegensatz zu dem gemäß dem Stand der Technik zu erwartenden Ergebnis, nämlich daß beim Hartstoffbeschichten von aluminiumhältigen Stählen eine Oberflächennitrierung des Grundkörpers eintritt, die ein Verspröden der Grenzschicht bewirkt, ergab es sich, daß das im Grundkörper enthaltene Aluminium die Bindung zwischen der Hartstoffschicht und dem Grundkörper verstärkt, indem es sich mit den Metallen der Hartstoffschicht verbindet; durch die chemische Affinität des Aluminiums zu den Metallen in der Hartstoffschicht entstehen Bindungsvalenzen. Besonders gut ist diese Verbindung, wenn die Zwischenschicht zwischen der Hartstoffschicht und dem Grundkörper die auch nicht zu Nitriden, Carbiden usw. abgebundenen Metalle enthält.

Auch die erwarteten spröden bzw. weichen Verbindungen bzw. Phasen zwischen Aluminium einerseits und Titan, Hafnium und Zirkon andererseits treten nicht auf. Auch eine Verringerung der Härte der Hartstoffschicht bzw. des Grundkörpers durch das zulegierte Aluminium bzw. durch beim Beschichten mitaufgebrachtes Aluminium bzw. durch Aluminiumverbindungen tritt nicht auf. Durch die Ablagerung von Aluminium im Zuge der Ausbildung der Hartstoffschicht kann die Bindung der abgelagerten Hartstoffschicht bzw. der Zwischenschicht sogar noch verbessert werden. Die befürchteten Reaktionen des Aluminiums mit Stickstoff, Kohlenstoff bzw. Sauerstoff während der Schichtausbildung traten nicht ein bzw. wurden durch die Affinität des Aluminiums im Grundkörper zu den Metallen der Hartstoffschicht überwogen. Aufgrund dieser Bindungsverbesserung ist die kritische Einhaltung der Gaskonzentrationen, aus denen die Hartstoffschicht abgelagert wird, nicht mehr so von Bedeutung wie bisher.

Das erfindungsgemäße Verfahren zur Herstellung eines Verschleißteils, insbesondere eines Werkzeugs, mit einem Grundkörper aus einer aluminiumhältigen Eisenbasislegierung, vorzugsweise aus einem Werkzeugstahl, insbesondere einem Schnellarbeitsstahl, ist erfindungsgemäß dadurch gekennzeichnet, daß der Grundkörper des Verschleißteils aus einem, das Aluminium in einem Ausmaß von 0,1 bis 6 Gew.-%, vorzugsweise 0,2 bis 2,5 Gew.-%, insbesondere 1 bis 1,6 Gew.-%, enthaltenden Legierungsmaterial geformt bzw. erschmolzen bzw. hergestellt wird und daß mittels PVD oder Plasma-CVD-Beschichtungsverfahrens zumindest im Bereich der Verschleißflächen des Grundkörpers zumindest eine Hartstoffschicht, enthaltend im wesentlichen Nitride und/oder Oxinitride und/oder Carbide, und/oder Carbonitride und/oder Oxicarbonitride der Metalle Ti und/oder Hf und/oder Zr und gegebenenfalls Al, abgelagert wird.

Vorteilhafterweise wird dabei zur Erhöhung der Haftfestigkeit zwischen der Hartstoffschicht und dem Grundmaterial derart vorgegangen, daß zwischen der Hartstoffschicht und dem Grundkörper eine neben Nitriden und/oder Oxinitriden und/oder Carbiden und/oder Carbonitriden und/oder Oxicarbonitriden der Metalle Ti und/oder Hf und/oder Zr und gegebenenfalls Al auch diese Metalle selbst enthaltende Zwischenschicht, vorzugsweise mit einer Dicke im Bereich von 0,05 bis 0,3 $\mu$m, vorzugsweise mit etwa 0,1 $\mu$m, abgelagert wird.

Bei der Herstellung der Verschleißteile wird derart vorgegangen, daß die Legierungsbestandteile gemeinsam mit dem Aluminium erschmolzen werden und die Grundkörper der Verschleißteile in der gewünschten Form durch entsprechende spanende oder nichtspanende Formgebungsverfahren hergestellt und vergütet bzw. gehärtet und angelassen werden. Daraufhin wird mittels PVD-Verfahrens, insbesondere bei Temperaturen von 300 bis 500°C, oder mittels Plasma-CVD-Verfahrens, insbesondere bei Temperaturen kleiner 500°C zumindest eine Hartstoffschicht in der üblichen Weise auf dem Grundkörper abgelagert. Die Ausbildung der Zwischenschicht erfolgt durch entsprechende Einregelung der Ablagerungscharakteristik.

Die Dicke der Hartstoffschicht liegt im üblichen Rahmen von etwa 0,5 bis 20 $\mu$m, insbesondere bei etwa 1 bis 5 $\mu$m. Die Dicke der Zwischenschicht ist entsprechend kleiner und liegt im Bereich von 0,05 bis 0,2 $\mu$m.

Verschleißteile, die mit derartigen Verfahren gut herstellbar sind, sind vor allem Werkzeuge für die spanende bzw. spanlose Formgebung.

Die erfindungsgemäße Vorgangsweise ergab besonders gute Ergebnisse bei der Ablagerung von Nitride und/oder Oxinitride und/oder Karbide enthaltenden Hartstoffschichten. Insbesondere wurden die Hartstoffschichten mit einer Ion-Plating-PVD-Anlage oder Sputteranlage abgelagert.

Im folgenden wird die Erfindung anhand von Beispielen näher erläutert:

Beispiel 1:

Spiralbohrer, bestehend aus den Legierungen S 6-5-2 (Werkstoff-Nr. 1.3343, Typ B in der nachfolgenden Tabelle), wurden nach einer Reinigung mit Alkohol in eine Ion-Plating-PVD-Beschichtungsanlage eingebaut und auf 450°C im Vakuum erhitzt.

Danach wurde die Oberfläche durch Ionenätzung während einer Zeit von 20 Minuten gereinigt. Unmittelbar daran anschließend wurde mit einer Elektronenstrahlkanone metallisches Titan verdampft und ein Stickstoff-partialdruck von $5.10^{-3}$ mbar eingestellt. Nach 30 Minuten hatte sich auf der Oberfläche der Spiralbohrer ein 4 μm dicker Hartstoffbelag, bestehend aus TiN, gebildet. Der erfindungsgemäß eingesetzte Grundwerkstoff (Tabelle: B 3) hatte einen Gehalt von 2,52 Gew.-% Al gegenüber 0,003 Gew.-% Al in dem herkömmlichen Grundwerkstoff.

Beispiel 2:

Walzenstirnfräser, bestehend aus den Legierungen S 10-4-3-10 (Werkstoff-Nr. 1.3207, Tabelle: Typ D) wurden analog dem Beispiel 1 in einer Ion-Plating-PVD-Anlage behandelt. Abweichend von Beispiel 1 wurde unmittelbar nach der Ionenätzung metallisches Zirkon verdampft und der Stickstoffpartialdruck auf $3.10^{-3}$ mbar eingestellt. Nach 10 Minuten wurde zusätzlich $CH_4$ eingeleitet und der Druck auf $4.10^{-3}$ mbar angehoben. Nach 40 Minuten hatte sich auf der Oberfläche der Fräser eine ca. 4,2 μm dicke Hartstoffbeschichtung, bestehend aus ZrN mit einer Deckbeschichtung aus Zirkonkarbonitrid gebildet. Der erfindungsgemäß eingesetzte Grundwerkstoff enthielt 1,11 Gew.-% Al (D 3), während der Vergleichswerkstoff (D 1) 0,0025 Gew.-% Al enthielt.

Beispiel 3:

Schneidstempel, bestehend aus den Legierungen S 2-9-2 (Werkstoff-Nr. 1.3348, Tabelle: Typ C) wurden nach einer Vorreinigung mit Aceton in einer Sputteranlage eingebaut und durch eine Glimmentladung bei einem Druck von $1.10^{-2}$ mbar Ar-sputtergereinigt und gleichzeitig aufgeheizt.

Nach einer Behandlungsdauer von 30 Minuten hatten die Schneidstempel eine Temperatur von 380°C erreicht. Danach wurden die Werkzeuge in der Anlage durch Drehung weiterbewegt und über ein Sputtertarget, bestehend aus 95 % Ti und 5 % Al, positioniert. Durch Anlegung einer negativen Spannung an das Sputtertarget wurde zwischen den Werkzeugen und dem Target eine Gasentladung (Plasma) gezündet.

Nach ca. 2 Minuten wurde der Ar-Druck auf $5.10^{-3}$ mbar abgesenkt und Stickstoff bis zu einem Druck von $1,5.10^{-2}$ mbar eingeleitet. Nach 20 Minuten wiesen die Schneidstempel eine ca. 3 μm dicke Schicht an TiAlN auf.

Der erfindungsgemäß eingesetzte Werkstoff (C 2) enthielt 1,51 Gew.-% Al, der Vergleichswerkstoff (C 1) enthielt 0,002 Gew.-% Al.

Es wurden mit den aus einem erfindungsgemäßen Grundwerkstoff hergestellten und mit der erfindungsgemäßen Hartstoffschicht beschichteten Werkzeugen und den aus Al in bekannten geringen Mengen enthaltenden Schnellarbeitsstählen hergestellten, beschichteten Werkzeugen vergleichende Werkstoffbearbeitungen durchgeführt.

Bohren

Bearbeiteter Werkstoff  42 CrMo 4 (W.Nr. 1.7225)
Schnittgeschwindigkeit  V = 28 m/min
Vorschub  s = 0,125 mm/U
Bohrerdurchmesser  Ø = 8 mm
Standardbeschichtung auf einem Al-freien Grundwerkstoff (S 6-5-2) :
    Bohrweg 3400 mm
    $V_B$ = 0,08
Erfindungsgemäßes Werkzeug gemäß Beispiel 1:
    Bohrweg 4600 mm
    $V_B$ = 0,08

Bohren

Bearbeiteter Werkstoff  40 NiCrMo 6 (W.-Nr. 1.6565) vergütet auf 870 N/mm²
Schnittgeschwindigkeit  V = 45 m/min

Vorschub                          s = 0,15 mm/U
Bohrerdurchmesser                 Ø 6 mm
Al-freier beschichteter Grundwerkstoff (S 10-4-3-10) :
    Anzahl der Bohrungen 326
Erfindungsgemäßer Al-hältiger beschichteter Grundwerkstoff gemäß Beispiel 2:
    Anzahl der Bohrungen 516

Fräsen

Bearbeiteter Werkstoff            Ck45 (W.Nr. 1.1495)
Schnittgeschwindigkeit            V = 71 m/min
Vorschub                          0,107 mm/Zahn
Trockenschnitt
Zerspanungsvolumen bei Al-freiem beschichtetem Standard-Stahl (S 2-9-2):
    1200 cm$^2$ $V_B$ = 0,12 mm Freiflächenverschleiß
Erfindungsgemäßes Werkzeug gemäß Beispiel 3:
    1600 cm$^2$ $V_B$ = 0,11 mm Freiflächenverschleiß
Stanzen von Blech mit einer Dicke von 4,6 mm Werkstoff Ck15 (Werkstoff Nr. 1.1141) :
Al-freier hartstoffbeschichteter Grundwerkstoff (Typ A aus der Tabelle) : 420 Stanzungen
Al-hältiger erfindungsgemäßer beschichteter Grundwerk. stoff (A 2): 615 Stanzungen

Im folgenden ist eine Tabelle angeführt, in der einzelne Legierungszusammensetzungen für Al-hältige Eisenbasislegierungen mit entsprechendem hohen Al-Gehalt angeführt sind, welche gegenüber den geringen Al-Gehalt (z.B. 0,002 bis 0,004) besitzenden Legierungen die Anfertigung beschichteter Werkzeuge ermöglichen, welche den herkömmlich hergestellten Werkzeugen deutlich überlegen sind.

| Typ | | | %C | %Cr | %Mo | % V | % W | %Co | %Al |
|---|---|---|---|---|---|---|---|---|---|
| A | A1 | Vergl.Leg. | 0,75 | 4,3 | – | 1,1 | 18,0 | – | 0,004 |
|   | A2 | | 0,75 | 4,3 | – | 1,1 | 18,0 | – | 0,52 |
|   | A3 | | 0,75 | 4,3 | – | 1,1 | 18,0 | – | 1,56 |
| B | B1 | Vergl.Leg. | 1,0 | 4,3 | 5,0 | 1,9 | 6,4 | – | 0,003 |
|   | B2 | | 1,0 | 4,3 | 5,0 | 1,9 | 6,4 | – | 1,02 |
|   | B3 | | 1,0 | 4,3 | 5,0 | 1,9 | 6,4 | – | 2,52 |
| C | C1 | Vergl.Leg. | 1,0 | 3,8 | 8,7 | 2,1 | 1,8 | – | 0,002 |
|   | C2 | | 1,0 | 3,8 | 8,7 | 2,1 | 1,8 | – | 1,51 |
|   | C3 | | 1,0 | 3,8 | 8,7 | 2,1 | 1,8 | – | 3,08 |
| D | D1 | Vergl.Leg. | 1,26 | 4,3 | 3,8 | 3,2 | 9,8 | 10,4 | 0,0025 |
|   | D2 | | 1,26 | 4,3 | 3,8 | 3,2 | 9,8 | 10,4 | 0,27 |
|   | D3 | | 1,26 | 4,3 | 3,8 | 3,2 | 9,8 | 10,4 | 1,11 |

**Patentansprüche**

1. Verschleißteil, insbesondere Werkzeug, mit einem Grundkörper aus einer Al-hältigen Eisenbasislegierung, vorzugsweise Werkzeugstahl, insbesondere Schnellarbeitsstahl, dadurch gekennzeichnet, daß der, das Aluminium in seinem Ausmaß von 0,1 bis 6 Gew.-% enthaltende Grundkörper des Verschleißteiles zumindest an seiner Verschleißfläche mit zumindest einer durch PVD- oder Plasma- CVD-Beschichtungsverfahren abgelagerten Hartstoffschicht versehen ist, wobei die Hartstoffschicht im wesentlichen aus Nitriden und/oder Oxinitriden und/oder Karbiden und/oder Karbonitriden und/oder Oxikarbonitriden der Metalle Ti und/oder HF und-/oder Zr und gegebenenfalls Al aufgebaut ist.

2. Verschleißteil nach Anspruch 1, dadurch gekennzeichnet, daß der Grundkörper Aluminium im Bereich von 0,2 bis 2,5 Gew.-% enthält.

3. Verschleißteil nach Anspruch 1, dadurch gekennzeichnet, daß der Grundkörper Aluminium im Bereich von 1 bis 1,6 Gew.-% enthält.

4. Verschleißteil nach Anspruch 1,2 oder 3, dadurch gekennzeichnet, daß zwischen der Hartstoffschicht und dem Grundkörper eine neben den Nitriden und/oder Oxinitriden und/oder Karbiden und/oder Karbonitriden und/oder Oxikarbonitriden der Metalle Ti und/oder Hf und/oder Zr und gegebenenfalls Al auch diese Metalle selbst enthaltende Zwischenschicht angeordnet ist.

5. Verschleißteil nach einem der Ansprüche 1 bis 4, dadurch gekennzeichnet, daß die Dicke der Zwischenschicht im Bereich von o,o5 bis o,2 μm, vorzugsweise bei etwa 0,1 μm, liegt.

6. Verfahren zur Herstellung eines Verschleißteiles, insbesondere eines Werkzeuges mit einem Grundkörper aus einer Al-hältigen Eisenbasislegierung, vorzugsweise einem Werkzeugstahl, insbesondere einem Schnellarbeitsstahl, dadurch gekennzeichnet, daß der Grundkörper aus einem, das Aluminium in einem Ausmaß von 0,1 bis 6 Gew.-% enthaltenden Legierungsanteil geformt bzw. erschmolzen bzw. hergestellt wird und daß mittels PVD- oder Plasma-CVD-Beschichtungsverfahrens zumindest im Bereich der Verschleißflächen des Grundkörpers zumindest eine Hartstoffschicht, enthaltend im wesentlichen Nitride und/oder Oxinitride und-/oder Karbide und/oder Karbonitride und/oder Oxikarbonitride der Metalle Ti und/oder Hf und/oder Zr und gegebenenfalls Al, abgelagert wird.

7. Verfahren nach Anspruch 6, dadurch gekennzeichnet, daß der Grundkörper aus einem das Aluminium in einem Ausmaß ven 0,2 bis 2,5 Gew.-% enthaltenden Legierungsmaterial hergestellt wird.

8. Verfahren nach Anspruch 6, dadurch gekennzeichnet, daß der Grundkörper aus einem das Aluminium in einem Ausmaß von 1 bis 1,6 Gew.-% enthaltenden Legierungsmaterial hergestellt wird.

9. Verfahren nach Anspruch 6,7 oder 8, dadurch gekennzeichnet, daß zwischen der Hartstoffschicht und dem Grundkörper eine neben Nitriden und/oder Oxinitriden und/oder Karbiden und/oder Karbonitriden und-/oder Oxikarbonitriden der Metalle Ti und/oder Hf und/oder Zr und gegebenenfalls Al auch diese Metalle selbst enthaltende Zwischenschicht, vorzugsweise mit einer Dicke im Bereich von 0,05 bis 0,2 μm, vorzugsweise mit etwa 0,1 μm, abgelagert wird.


## Claims

1. Wearing part, in particular tool, having a foundation made of an Al-containing iron base alloy, preferably tool steel, in particular high-speed steel, characterised in that the foundation of the wearing part, containing the aluminium in an amount of 0.1 to 6% by weight, is provided at least on its wear surface with at least one layer of hard material deposited by PVD or plasma-CVD coating processes, the layer of hard material being constructed substantially of nitrides and/or oxynitrides and/or carbides and/or carbonitrides and/or oxycarbonitrides of the metals Ti and/or Hf and/or Zr and optionally Al.

2. Wearing part according to Claim 1, characterised in that the foundation contains aluminium in the range of 0.2 to 2.5% by weight.

3. Wearing part according to Claim 1, characterised in that the foundation contains aluminium in the range of 1 to 1.6% by weight.

4. Wearing part according to Claim 1, 2 or 3, characterised in that an intermediate layer also containing, in addition to the nitrides and/or oxynitrides and/or carbides and/or carbonitrides and/or oxycarbonitrides of the metals Ti and/or Hf and/or Zr and optionally Al, these metals themselves is disposed between the layer of hard material and the foundation.

5. Wearing part according to one of Claims 1 to 4, characterised in that the thickness of the intermediate layer is in the range of 0.05 to 0.2 μm, preferably about 0.1 μm.

6. Method for producing a wearing part, in particular a tool, having a foundation made of an Al-containing iron base alloy, preferably a tool steel, in particular a high-speed steel, characterised in that the foundation is shaped or smelted or produced from an alloying contribution containing the aluminium in an amount of 0.1 to 6% by weight, and that at least one layer of hard material, containing substantially nitrides and/or oxynitrides and/or carbides and/or carbonitrides and/or oxycarbonitrides of the metals Ti and/or Hf and/or Zr and optionally Al, is deposited by means of a PVD or plasma-CVD coating process at least in the region of the wear surfaces of the foundation.

7. Method according to Claim 6, characterised in that the foundation is made from an alloy material containing the aluminium in an amount of 0.2 to 2.5% by weight.

8. Method according to Claim 6, characterised in that the foundation is made from an alloy material containing the aluminium in an amount of 1 to 1.6% by weight.

9. Method according to Claim 6, 7 or 8, characterised in that an intermediate layer preferably having a thickness in the range of 0.05 to 0.2 µm, preferably about 0.1 µm, and also containing, in addition to nitrides and/or oxynitrides and/or carbides and/or carbonitrides and/or oxycarbonitrides of the metals Ti and/or Hf and/or Zr and optionally Al, these metals themselves is deposited between the layer of hard material and the foundation.

## Revendications

1. Pièce d'usure, en particulier outil, avec un corps de base en un alliage à base de fer à teneur en Al, de préférence un acier à outils, en particulier un acier à coupe rapide, caractérisée en ce que le corps de base de la pièce d'usure, contenant l'aluminium dans une proportion de 0,1 à 6 % en poids, est pourvu, au moins sur sa face d'usure, d'au moins une couche de matériau dur déposée par un procédé de revêtement PVD ou CVD au plasma, la couche de matériau dur étant constituée essentiellement de nitrures et/ou d'oxynitrures et/ou de carbures et/ou de carbonitrures et/ou d'oxycarbonitrures des métaux Ti et/ou Hf et/ou zr et éventuellement d'Al.

2. Pièce d'usure suivant la revendication 1, caractérisée en ce que le corps de base contient de l'aluminium de l'ordre de 0,2 à 2,5 % en poids.

3. Pièce d'usure suivant la revendication 1, caractérisée en ce que le corps de base contient de l'aluminium de l'ordre de 1 à 1,6 % en poids.

4. Pièce d'usure suivant la revendication 1, 2 ou 3, caractérisée en ce que, entre la couche de matériau dur et le matériau d'alliage ou le substrat, il est disposé une couche intermédiaire contenant, outre les nitrures et/ou oxynitrures et/ou carbures et/ou carbonitrures et/ou oxycarbonitrures des métaux Ti et/ou Hf et/ou zr et éventuellement d'Al, également ces métaux proprement-dits.

5. Pièce d'usure suivant l'une des revendications 1 à 4, caractérisée en ce que l'épaisseur de la couche intermédiaire est de l'ordre de 0,05 à 0,2 µm, de préférence d'environ 0,1 µm.

6. Procédé de fabrication d'une d'une pièce d'usure, en particulier un outil, avec un corps de base en un alliage à base de fer à teneur en Al, de préférence un acier à outils, en particulier un acier à coupe rapide, caractérisé en ce que le corps de base est formé, fondu ou réalisé en un matériau d'alliage contenant l'aluminium dans une proportion de 0,1 à 6 % en poids et que, par un procédé de revêtement PVD ou CVD au plasma, au moins dans la zone des faces d'usure du corps de base, il est déposé au moins une couche de matériau dur contenant essentiellement des nitrures et/ou des oxynitrures et/ou des carbures et/ou des carbonitrures et/ou des oxycarbonitrures des métaux Ti et/ou Hf et/ou zr et éventuellement d'Al.

7. Procédé suivant la revendication 6, caractérisé en ce que le corps de base est fabriqué en un matériau d'alliage contenant l'aluminium dans une proportion de 0,2 à 2,5 % en poids

8. Procédé suivant la revendication 6, caractérisé en ce que le corps de base est fabriqué en un matériau d'alliage contenant l'aluminium dans une proportion de 1 à 1,6 % en poids

9. Procédé suivant la revendication 6, 7 ou 8, caractérisé en ce que, entre la couche de matériau dur et le matériau d'alliage ou le substrat, il est déposé une couche intermédiaire, de préférence d'une épaisseur de l'ordre de 0,05 à 0,2 µm, de préférence d'environ 0,1 µm, contenant, outre les nitrures et/ou oxynitrures et/ou carbures et/ou carbonitrures et/ou oxycarbonitrures des métaux Ti et/ou Hf et/ou zr et éventuellement d'Al, également ces métaux proprement-dits.